(19) Europäisches Patentamt / European Patent Office / Office européen des brevets

(11) **EP 3 516 925 B1**

(12) **EUROPÄISCHE PATENTSCHRIFT**

(45) Veröffentlichungstag und Bekanntmachung des Hinweises auf die Patenterteilung:
**17.06.2020   Patentblatt 2020/25**

(21) Anmeldenummer: **17755502.6**

(22) Anmeldetag: **22.08.2017**

(51) Int Cl.:
**H05B 3/26** (2006.01)

(86) Internationale Anmeldenummer:
**PCT/EP2017/071086**

(87) Internationale Veröffentlichungsnummer:
**WO 2018/054629 (29.03.2018 Gazette 2018/13)**

(54) **INFRAROTFLÄCHENSTRAHLER**

INFRARED FLAT RADIATOR

RADIATEUR PLAN À INFRAROUGE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **26.09.2016   DE 102016118137**

(43) Veröffentlichungstag der Anmeldung:
**31.07.2019   Patentblatt 2019/31**

(73) Patentinhaber: **Heraeus Noblelight GmbH 63450 Hanau (DE)**

(72) Erfinder:
• **GAAB, Lotta 64289 Darmstadt (DE)**
• **PIELA, Thomas 63450 Hanau (DE)**
• **STERNKIKER, Christoph 63457 Hanau (DE)**
• **WEBER, Jürgen 63801 Kleinostheim (DE)**

(74) Vertreter: **Heraeus IP Heraeus Holding GmbH Intellectual Property Heraeusstraße 12-14 63450 Hanau (DE)**

(56) Entgegenhaltungen:
EP-A1- 0 495 770          WO-A1-2012/139883
DE-T5-112014 003 822      DE-U1- 20 202 810
FR-A- 979 374             US-A1- 2014 314 396

**Beschreibung**

Technischer Hintergrund

Die vorliegende Erfindung betrifft einen Infrarotflächenstrahler, aufweisend einen Träger mit einer Heizfläche und mit einer auf einer Leiterbahnbelegungsfläche des Trägers aufgebrachten Leiterbahn aus einem elektrisch leitenden und bei Stromdurchfluss wärmeerzeugenden Widerstandsmaterial, wobei die Leiterbahn einen ersten Leiterbahn-Abschnitt zur Erzeugung einer ersten Flächenleistung und einen zweiten Leiterbahn-Abschnitt zur Erzeugung einer von der ersten Flächenleistung abweichenden, zweiten Flächenleistung umfasst,
Infrarotflächenstrahler im Sinne der Erfindung zeigen eine Heizfläche mit flächig ausgedehnter, zwei- oder dreidimensionaler Abstrahlungscharakteristik; sie können aufgrund ihrer flächenhaften Abstrahlungscharakteristik einfach an die Geometrie einer zu beheizenden Oberfläche eines Heizguts angepasst werden, sodass eine homogene Bestrahlung zwei- oder dreidimensionaler Heizgut-Oberflächen ermöglicht wird.

Erfindungsgemäße Infrarotflächenstrahler werden insbesondere für thermische Heizprozesse eingesetzt, beispielsweise zur thermischen Behandlung von Halbleiterscheiben in der Halbleiter- oder Photovoltaik-Industrie, in der Druckindustrie oder der Kunststoffverarbeitung. Beispielsweise finden erfindungsgemäße Infrarotflächenstrahler Anwendung beim Polymerisieren von Kunststoffen, beim Aushärten von Lacken oder beim Trocknen von Farben. Sind darüber hinaus in einer Vielzahl von Trocknungsprozessen einsetzbar, beispielsweise bei der Herstellung von Folien oder Garnen oder der Fertigung von Modellen, Mustern, Prototypen, Werkzeugen oder Endprodukten *(Additive Manufacturing).* Ein weiteres wichtiges Anwendungsgebiet ist die Herstellung flexibler gedruckter Elektronik, insbesondere im Rolle-zu-Rolle-Verfahren (R2R-Verfahren), bei dem Trocknungs- und Sinterprozesse unmittelbar nacheinander ablaufen.

Stand der Technik

Für die thermische Behandlung von Heizgütern werden häufig Infrarotflächenstrahler eingesetzt. Bekannte Infrarotflächenstrahler können unterschiedliche Bauformen aufweisen. Beispielsweise sind Infrarotflächenstrahler bekannt, bei denen mehrere Infrarotstrahler mit zylinderförmigem Strahlerrohr derart in einem Strahlermodul angeordnet sind, dass ihre Strahlerrohr-Längsachsen parallel zueinander in einer Ebene verlaufen. Weiterhin sind Infrarotflächenstrahler gemäß der eingangs genannten Gattung bekannt, bei denen ein Widerstands-Heizelement unmittelbar auf der Oberfläche eines flächigen Trägers aufgebracht ist.

Die beiden zuvor beschriebenen Bauformen unterscheiden sich in der Wärmeübertragung. Während im erstgenannten Fall die Wärmeübertragung von einem in dem Strahlerrohr angeordneten Heizelement auf das Strahlerrohr vorrangig durch Wärmestrahlung erfolgt, steht im zweitgenannten Fall das Heizelement in unmittelbarem Kontakt mit dem flächigen Träger, sodass die Wärmeübertragung von dem Heizelement auf den Träger überwiegend durch Wärmeleitung und Konvektion erfolgt.

Infrarotflächenstrahler mit einem auf den Träger aufgebrachten Heizelement zeigen eine gute Leistungseffizienz. Liegt bei diesen Infrarotflächenstrahlern eine Spannung am Widerstands-Heizelement an, wird dieses über seine gesamte Länge gesehen mit einer im Wesentlichen konstanten elektrischen Leistung betrieben.

Es hat sich jedoch gezeigt, dass ein Betrieb eines Heizelements mit einer konstanten elektrischen Leistung mit Temperaturunterschieden, insbesondere einer ungleichmäßigen Temperaturverteilung auf der Heizfläche des Trägers einhergehen kann. Insbesondere an den Rändern des Trägers werden regelmäßig niedrigere Temperaturen gemessen als beispielsweise im Mittenbereich des Trägers. Ein Grund hierfür ist, dass im Träger-Randbereich gegenüber dem Mittenbereich höhere Energieverluste durch Konvektion auftreten können. Dies geht insbesondere im Randbereich des Trägers mit einer geringeren Temperatur und bezogen auf den gesamten Träger mit einer ungleichmäßigen Temperaturverteilung einher.

Es ist daher bekannt, dass der Randbereich und der Mittenbereich eines Trägers unterschiedlich stark erwärmt werden müssen, um eine möglichst homogene Träger-Temperatur und damit einhergehend eine möglichst homogene Strahlungsemission der eigentlichen Heizfläche zu erhalten.

Es sind Infrarotflächenstrahler mit flächigem Träger bekannt, bei denen die Leiterbahnmehrere, parallel geschaltete Leiterbahn-Abschnitte aufweist. Die Parallelschaltung soll dazu beitragen, dass die Leiterbahn einen möglichst geringen Gesamtwiderstand aufweist und daher mit hohen Betriebsströmen und damit einhergehend mit hohen Leistungen betrieben werden kann. Zur Kompensation von Randzonen-Effekten werden die Leiterbahn-Abschnitte mit unterschiedlichen Flächenleistungen betrieben, wobei die Leiterbahn-Abschnitte meist durch Einsatz von Drucktechniken erzeugt sind, beispielsweise durch Sieb- oder Tintenstrahldruck. In der Regel ist bei diesen Strahlern insbesondere dem Randbereich des Trägers ein Leiterbahn-Abschnitt zugeordnet, der mit einer höheren Flächenleistung betrieben werden kann. Dies hat den Vorteil, dass konvektionsbedingte Temperaturverluste im Bereich der Randzonen durch die höhere Flächenleistung der diesem Bereich zugeordneten Leiterbahn ausgeglichen werden können.

Aus der DE 10 2014 108 356 A1 ist ein Infrarotflächenstrahler bekannt, bei dem auf ein Träger eine Widerstandsstruktur aufgebracht ist. Die Widerstandsstruktur umfasst eine innenliegende Leiterbahn und eine parallel dazu geschaltete, außenliegende Leiterbahn, die sich in ihren Widerständen unterscheiden. Eine solche Widerstandsstruktur macht sich den Effekt zu Nutze, dass die Leiterbahn mit dem geringeren Widerstand einen höheren Beitrag zur Heizleistung beisteuert. Auf diese Weise wird der Ausbildung von sogenannten *"cold spots"* beziehungsweise einem Leistungsabfall im Bereich der Randzone entgegengewirkt.

Eine Parallelschaltung von Heizwiderständen hat den Vorteil, dass diese einen besonders niedrigen Gesamtwiderstand aufweist. Ein geringer Gesamtwiderstand geht bei vorgegebener, konstanter Betriebsspannung mit einer hohen Betriebsstromstärke einher und ermöglicht einen Betrieb des Infrarotflächenstrahlers mit hoher Leistung. Das Vorsehen parallel geschalteter Heizwiderstände hat allerdings Einfluss auf das Leiterbahn-Design, also die Anordnung und Geometrie der Leiterbahn-Abschnitte. Insbesondere können durch die gewünschte Temperaturverteilung die Widerstände der Parallelteilkreise und die Position der Parallelabzweigungen vom Hauptkreis vorgegeben sein. Hierbei kann es sein, dass durch die vorgegebene Position der Parallelkreis-Abzweigungen einerseits das Leiterbahn-Design nicht mehr frei wählbar ist. Darüber hinaus kann sich insbesondere im Bereich der Parallel-Abzweigung eine höhere Leiterbahn-Belegungsdichte ergeben, die wiederum Einfluss auf die Temperaturverteilung auf dem Träger, insbesondere der Heizfläche, haben kann.

DE 202 02 810 U1 betrifft einen elektrischen Flächenheizkörper mit einer Frontplatte, einer Trägerplatte und einer Halterung oder einem Fußteil, wobei die Trägerplatte aus nicht-stromleitendem Material mit geringem Wärmeausdehnungskoeffizienten eine beheizbare Deckschicht aufweist.

US 2014/0314396 A1 betrifft ein elektrothermisches Element mit einem Substrat, einer Reflektorschicht, einer elektrothermischen Schicht und einer Hilfsschicht.

WO 2012/139883 A1 betrifft einen Flächenheizkörper mit zumindest einem Substrat mit einer Substratfläche, einer elektrischen Heizschicht zum Heizen des Substrats, die durch Trennzonen elektrisch unterteilt ist.

DE 11 2014 003 822 T5 betrifft eine Folienheizung für eine Heizplatte für das Heizen des Fahrgastraums eines Fahrzeugs.

EP 0 495 770 A1 betrifft einen Infrarotstrahler aus einer Trägerplatte aus Stahlblech, das mit einem Dielektrikum auf keramischer Basis oder aus Email beschichtet ist oder aus Aluminiumoxid, auf die wenigstens eine Leiterbahn aus Metalloxid aufgebracht ist.

FR 979 374 A betrifft ein Heizelement für eine Heizdecke mit einem oder mehreren Heizleitern.

Technische Aufgabe

Der vorliegenden Erfindung liegt daher die technische Aufgabe zugrunde, einen Infrarotflächenstrahler mit hoher Bestrahlungsleistung anzugeben, der zur Emission von Strahlung mit einer möglichst gleichmäßigen Bestrahlungsstärke ausgelegt ist.

Allgemeine Beschreibung der Erfindung

Die oben genannte Aufgabe wird ausgehend von einem Infrarotflächenstrahler der eingangs genannten Gattung erfindungsgemäß dadurch gelöst, dass der Träger einen Komposit-Werkstoff enthält, der eine amorphe Matrixkomponente sowie eine in die amorphe Matrixkomponente eingelagerte Zusatzkomponente in Form eines Halbleitermaterials umfasst, und dass der erste Leiterbahn-Abschnitt und der zweite Leiterbahn-Abschnitt in Reihe geschaltet sind und sich in ihrer Belegungsdichte und/oder ihrem Leiterquerschnitt voneinander unterscheiden.
Der vorliegenden Erfindung liegt die Erkenntnis zugrunde, dass ein Infrarotflächenstrahler mit hoher Bestrahlungsstärke und besonders homogener Strahlungsemission erhalten werden kann, wenn dieser einerseits aus einem Komposit-Werkstoff mit hohem Emissionsgrad gefertigt ist und andererseits das Leiterbahn-Design durch Reihenschaltung mehrerer Leiterbahn-Abschnitte, auf den Komposit-Werkstoff abstimmbar ist, indem sich die Leiterbahn-Abschnitte in ihrer Belegungsdichte und/oder in ihrem Leiterquerschnitt voneinander unterscheiden. Durch diese Abstimmbarkeit wird erreicht, dass die Heizfläche IR-Strahlung mit einer homogenen Bestrahlungsstärke emittiert, oder anders gesagt: dass bei Anlegen einer Spannung an die Leiterbahn eine im wesentlichen gleichmäßige Temperaturverteilung auf der Heizfläche erhalten wird.

Der erfindungsgemäße Infrarotflächenstrahler unterscheidet sich somit von herkömmlichen Infrarotflächenstrahlern in zwei Gesichtspunkten, nämlich einerseits in der chemischen Zusammensetzung des Trägers oder mindestens eines Teils des Trägers, der aus einem spezifischen Komposit-Werkstoff gefertigt ist und andererseits im Leiterbahn-Design, das speziell auf die Zusammensetzung des Komposit-Werkstoffs abgestimmt ist.

Dadurch, dass der Träger eine amorphe Matrixkomponente sowie eine Zusatzkomponente in Form eines Halbleitermaterials umfasst, wird ein Träger erhalten, das bei thermischer Anregung einen energiereichen, angeregten Zustand einnehmen kann. Insbesondere die physikalischen Eigenschaften des Trägers werden durch die Zusatzkomponente beeinflusst. Es hat sich gezeigt, dass durch den Zusatz eines Halbleitermaterials ein Träger erhalten wird, das zur Emission von Infrarotstrahlung mit hoher Bestrahlungsstärke geeignet ist. Gleichzeitig zeigt der Komposit-Werkstoff eine temperaturabhängige Wärmeleitfähigkeit, die ebenfalls auf dem Zusatz des Halbleitermaterials beruht.

Der Komposit-Werkstoff umfasst dabei folgende Komponenten:

- Die amorphe Matrixkomponente stellt hinsichtlich Gewicht und Volumen den größten Anteil des Komposit-Werkstoffs dar. Sie bestimmt maßgeblich die mechanischen und chemischen Eigenschaften des Komposit-Werkstoffs; beispielsweise dessen Temperaturbeständigkeit, Festigkeit und Korrosionseigenschaften. Dadurch, dass die Matrixkomponente amorph ist - sie besteht vorzugsweise aus Glas - kann die geometrische Gestalt des Trägers im Vergleich zu einem Träger aus kristallinen Werkstoffen einfacher an die Anforderungen bei der spezifischen Anwendung des erfindungsgemäßen Infrarotflächenstrahlers angepasst werden.
  Die Matrixkomponente kann aus undotiertem oder dotiertem Quarzglas bestehen und gegebenenfalls außer $SiO_2$ in einer Menge bis maximal 10 Gew.- % andere oxidische, nitridische oder carbidische Komponenten enthalten. Zur Vermeidung einer vom Träger-Werkstoff ausgehenden Kontaminationsgefahr hat sich aber eine Ausführungsform des Infrarotflächenstrahlers besonders bewährt, bei dem die amorphe Matrixkomponente Quarzglas ist und vorzugsweise eine chemische Reinheit von mindestens 99,99 % $SiO_2$ und ein Cristobalit-Gehalt von höchstens 1% besitzt.
- Gemäß der Erfindung ist darüber hinaus vorgesehen, dass in die Matrixkomponente eine Zusatzkomponente in Form eines Halbleitermaterials eingelagert ist. Sie bildet eine eigene, in die amorphe Matrixkomponente dispergierte amorphe oder kristalline Phase. Sie trägt zu einem hohen Emissionsgrad bei, so dass ein Träger erhalten wird, der zur Emission von Infrarot-Strahlung mit hoher Strahlungsleistung geeignet ist.

Bei dem erfindungsgemäßen Infrarotflächenstrahler dient die auf der Leiterbahnbelegungsfläche aufgebrachte Leiterbahn unmittelbar zur Erwärmung eines anderen Bauteils, nämlich des Trägers. Die Leiterbahn wirkt als "lokales" Heizelement, mit dem zumindest ein Teilbereich des Trägers lokal erwärmt werden kann; sie ist derart dimensioniert, dass sie einen Teil des Trägers erwärmt, der aus dem Komposit-Werkstoff gefertigt ist, der das eigentliche, Infrarotstrahlung emittierende Element des Trägers bildet. Dadurch, dass die Leiterbahn im Verbund mit dem Träger in unmittelbarem Kontakt mit der Leiterbahnbelegungsfläche des Trägers steht, wird ein besonders kompakter Infrarotflächenstrahler erhalten.

Das Leiterbahn-Design und die elektrische Schaltung der Leiterbahn-Abschnitte sind an die physikalischen Eigenschaften des thermisch anregbaren Komposit-Werkstoffs angepasst.

Die Wärmeleistung von herkömmlichen Infrarotflächenstrahlern, bei denen die Leiterbahn das eigentliche Heizelement bildet, hängt nach dem ohmschen Gesetz von dem elektrischen Gesamtwiderstand der Leiterbahn ab; bei ihnen kann die Wärmeleistung gesteigert werden, wenn der Leiterbahn-Gesamtwiderstandswert möglichst gering gewählt wird. Aus diesem Grund hat sich hier der Einsatz einer Parallelschaltung der Leiterbahn-Abschnitte als besonders günstig erwiesen, da ein Gesamtwiderstand erhalten wird, der kleiner ist als der kleinste Einzelwiderstand.

Im Gegensatz hierzu zeigt der erfindungsgemäße Infrarotflächenstrahler einen materialbedingten Absorptionsbereich, in dem eine thermische Anregung des Trägers möglich ist. Da die Flächenleistung vom Absorptionsbereich abhängt, ist nicht-wie bei herkömmlichen Infrarotflächenstrahlern - ein möglichst niedriger Gesamtwiderstand wünschenswert, sondern es hat sich vielmehr gezeigt, dass eine optimierte, effiziente Wärmeleistung erreicht werden kann, wenn die Flächenleistungen der Leiterbahnen und damit einhergehend deren Gesamtwiderstand auf den materialbedingten Absorptionsbereich abgestimmt ist.

Zur Erzielung einer optimalen Bestrahlungsstärke ist eine hinreichende thermische Anregung des Trägers notwendig. Dies wird erreicht, wenn die Leiterbahn und deren Abschnitte so geschaltet sind, dass genügend Energie zur thermischen Anregung des Trägers zur Verfügung steht. Ein darüber hinausgehender Energieeintrag trägt nur in begrenztem Umfang zur Steigerung der Bestrahlungsstärke bei und geht in der Regel mit einer geringeren Energieeffizienz einher.

Die zur Anregung des Trägers notwendige Energie kann einfach und kostengünstig mit einer Reihenschaltung von Leiterbahn-Abschnitten zur Verfügung gestellt werden. In Bezug auf den thermisch anregbaren Komposit-Werkstoff des Trägers hat die Reihenschaltung von Leiterbahn-Abschnitten darüber hinaus den Vorteil, dass eine Anregung mit einem besonders günstigen Strom-Spannungs-Verhältnis ermöglicht wird. Durch die Reihenschaltung der Leiterbahn-Widerstände werden Betriebsspannungen im Bereich von 100 V bis 400 V möglich. Gleichzeitig wird ein Betrieb der Leiterbahn-Abschnitte geringeren Betriebsströmen möglich, wodurch die Lebensdauer des erfindungsgemäßen Infrarotflächenstrahlers erhöht werden kann.

Schließlich kann dadurch, dass gemäß der Erfindung die Leiterbahn-Abschnitte in Reihe geschaltet sind, das Leiterbahn-Design flexibel an die jeweilige Anwendung angepasst werden. Insbesondere sind im Gegensatz zu einer Parallelschaltung von Leiterbahn-Abschnitten, bei der jeder Leiterbahn-Abschnitt einen Teilkreis bildet, keine Teilkreis-Abzweigungen notwendig, deren Position aufgrund des zu erzielenden Gesamtwiderstands vorgegeben sein können, sodass sie einer freien Gestaltung des Druckdesigns entgegenstehen können. Das frei wählbare Druckdesign ermöglicht eine Heizfläche mit einer besonders homogenen Bestrahlungsstärke, sodass eine besonders homogene thermische Behandlung des Heizguts ermöglicht wird.

Zur Kompensation einer ungleichmäßigen Temperaturverteilung, insbesondere um konvektionsbedingte Randzonen-Effekte zu kompensieren, weist die Leiterbahn des erfindungsgemäßen Infrarotflächenstrahlers mehrere Abschnitte auf, die sich in den mit ihnen erzielbaren Flächenleistungen unterscheiden, nämlich mindestens einen ersten und einen zweiten Leiterbahn-Abschnitt, wobei die Belegungsdichte und/oder der Leiterquerschnitt des ersten und des zweiten Leiterbahn-Abschnitts so aufeinander abgestimmt sind, dass bei Anlegen einer Spannung an die Leiterbahn eine im wesentlichen gleichmäßige Temperaturverteilung auf der Heizfläche erhalten wird.

Eine Einstellung der jeweiligen Flächenleistungen von erstem und zweitem Leiterbahn-Abschnitt kann beispielsweise über eine Variation der Belegungsdichte oder über eine Variation der Leiterquerschnitte der jeweiligen Leiterbahnen-Abschnitte oder über beides erfolgen.

Die Flächenleistung ist dabei definiert als die elektrische Anschlussleistung der Leiterbahn bezogen auf die von der Leiterbahn belegte Träger-Fläche. Dabei gilt als Träger-Fläche diejenige Fläche, die von einer Umhüllenden um die Leiterbahn umschlossen ist, wobei die Umhüllenden benachbarter Leiterbahn-Abschnitte ohne Abstand zueinander mittig zwischen den benachbarten Leiterbahnen verlaufen und etwaige Stromzuführungsleitungen nicht berücksichtigt werden. Die Träger-Fläche gibt somit den individuellen Oberflächenbereich an, der einem Leiterbahnabschnitt zugeordnet ist. Die Flächenleistung in einem Leiterbahn-Abschnitt ist umso höher, je höher die Leiterbahn-Belegungsdichte und je geringer der Leiterbahn-Leiterquerschnitt ist.

Der Leiterquerschnitt ist die in Stromflussrichtung betrachtete Querschnittsfläche durch die Leiterbahn. Bei einer schichtförmigen Leiterbahn mit Rechteckform ergibt sich der Leiterquerschnitt somit durch Multiplikation von Schichtbreite und Schichtdicke.

Die Belegungsdichte ist ein Maß dafür, wie dicht ein Träger-Abschnitt mit einer Leiterbahn belegt ist. Die Belegungsdichte wird prozentual als Flächen-Verhältnis angegeben, indem die mit der Leiterbahn belegte Oberfläche (als Projektion auf die Leiterbahnbelegungsfläche) auf die Träger-Fläche bezogen wird. Die Träger-Fläche umfasst dabei sowohl die mit der Leiterbahn belegte als auch die nicht mit der Leiterbahn belegte, "freie" Oberfläche der Leiterbahnbelegungsfläche.

Dadurch, dass die Leiterbahn mehrere solcher Leiterbahn-Abschnitte umfasst, wird die Ausbildung von Heizzonen ermöglicht, die sich in ihrer Flächenleistung unterscheiden. Die Heizzonen können so angeordnet werden, dass Temperaturverluste der Heizfläche ausgeglichen werden, sodass eine Heizfläche mit homogener Bestrahlungsstärke erhalten wird. Insbesondere ist eine Kompensation von Randzoneneffekten möglich, beispielsweise ist einer Randzone der Leiterbahnbelegungsfläche ein Leiterbahn-Abschnitt mit höherer Flächenleistung zugeordnet.

Ein solcher Infrarotflächenstrahler weist eine Heizfläche auf, die zur Erzielung von Bestrahlungsstärken ober-halb von 200 kW/m$^2$, vorzugsweise im Bereich von 200 kW/m$^2$ bis 250 kW/m$^2$ ausgelegt ist.

Bei einer bevorzugten Ausgestaltung des erfindungsgemäßen Infrarotflächenstrahlers ist der Träger vollständig aus dem Komposit-Werkstoff gefertigt, wobei der Komposit-Werkstoff ein elektrischer Isolator ist.

Der Träger mehrschichtig ausgeführt sein und außer dem Komposit-Werkstoff auch andere Werkstoffbereiche enthalten. Für den Betrieb des Infrarotflächenstrahlers ist es allerdings wesentlich, dass die Träger-Oberfläche zumindest im Bereich der Leiterbahnbelegungsfläche aus einem elektrisch isolierenden Werkstoff gefertigt ist. Hierdurch wird ein störungsarmer Betrieb des Infrarotflächenstrahlers gewährleistet, insbesondere werden Überschläge und Kurzschlüsse zwischen benachbarten Leiterbahn-Abschnitten verhindert. Dadurch, dass der Komposit-Werkstoff ein elektrischer Isolator ist, ist es möglich, die Leiterbahn unmittelbar auf den Komposit-Werkstoff und damit auf den Träger aufzubringen.

Ein aus mehreren Werkstoffen gefertigter Träger kann beispielsweise eine Schichtstruktur aufweisen, in der zwei oder mehrere Werkstoff-Schichten übereinander angeordnet sein können. Alternativ ist es auch möglich, dass der Träger einen Kern aus einem ersten Werkstoff, vorzugsweise dem Komposit-Werkstoff, aufweist, der mit einem Überzug aus einem zweiten Werkstoff überzogen ist. Der Kern kann vollständig oder teilweise mit dem zweiten Werkstoff überzogen sein. Vorzugsweise ist der Kern vollständig mit dem zweiten Werkstoff überzogen.

Bei einer bevorzugten Ausgestaltung des erfindungsgemäßen Infrarotflächenstrahlers ist der Komposit-Werkstoff zumindest im Bereich der Leiterbahnbelegungsfläche mit einer Schicht aus einem elektrisch isolierenden Werkstoff überzogen.

Der Komposit-Werkstoff, aus dem der Träger gefertigt ist, zeigt einen guten Emissionsgrad im Infrarotbereich. Neben dem Emissionsgrad des Komposit-Werkstoffs sind für dessen Eignung als Träger eines Infrarotflächenstrahlers weitere physikalische Eigenschaften des Komposit-Werkstoffs von Bedeutung, insbesondere dessen elektrische Leitfähigkeit. Die physikalischen Eigenschaften des Komposit-Werkstoffs werden in erster Linie durch die Komponenten bestimmt, aus denen der Komposit-Werkstoff zusammengesetzt ist. Je nach chemischer Zusammensetzung ist es daher möglich, dass der Komposit-Werkstoff entweder ein elektrischer Isolator ist, oder aber eine gewisse elektrische Leitfähigkeit aufweist. Ein elektrisch leitfähiger Komposit-Werkstoff kann aus den oben genannten Gründen nicht unmittelbar mit einer Leiterbahn versehen werden, da es während des Betriebs des Infrarotflächenstrahlers zu Kurzschlüssen kommen kann. Um dennoch aus einem elektrisch leitfähigen Komposit-Werkstoff einen Träger fertigen zu können, hat es sich als günstig erwiesen, wenn dieser zunächst mit einer Schicht aus einem elektrisch isolierenden Werkstoff überzogen wird. Der Komposit-Werkstoff kann vollständig oder teilweise mit einem elektrisch isolierenden Werkstoff überzogen sein. Jedenfalls sollte zumindest der Bereich des Trägers, dem die Leiterbahn zugeordnet ist - also die Leiterbahnbelegungsfläche - mit einer Schicht aus einem elektrisch isolierenden Werkstoff überzogen sein, beispielsweise mit einer Schicht aus Glas, insbesondere aus Quarzglas.

Bei einer weiteren bevorzugten Ausgestaltung des erfindungsgemäßen Infrarotflächenstrahlers ist vorgesehen, dass der Gewichtsanteil der Zusatzkomponente im Bereich zwischen 1 % und 5 %, vorzugsweise im Bereich zwischen 1,5 % und 3,5 % liegt.

Die Wärmeabsorption des Komposit-Werkstoffs hängt vom Anteil der Zusatzkomponente ab. Der Gewichtsanteil der Zusatzkomponente sollte daher vorzugsweise mindestens 1 % betragen. Andererseits kann ein hoher Volumenanteil der Zusatzkomponente die chemischen und mechanischen Eigenschaften der Matrix beeinträchtigen. Im Hinblick darauf liegt der Gewichtsanteil der Zusatzkomponente bevorzugt im Bereich zwischen 1 % und 5 %, vorzugsweise im Bereich zwischen 1,5 % und 3,5 %.

Es hat sich als günstig erwiesen, wenn die Leiterbahn als eingebrannte Dickfilmschicht ausgeführt ist oder wenn sie als Formstück derart auf die Oberfläche des Trägers aufgebracht ist, dass Leiterbahn und Träger dauerhaft miteinander verbunden sind.

Die Herstellung einer Leiterbahn kann durch verschiedene Fertigungsmethoden erfolgen, beispielsweise unter Einsatz von Drucktechniken, aber auch durch Stanzen, Laserstrahlschneiden oder Gießen.

Es hat sich als besonders günstig erwiesen, wenn die Leiterbahn als eingebrannte Dickfilmschicht ausgeführt ist. Derartige Dickfilmschichten werden beispielsweise aus Widerstandspaste mittels Siebdruck oder aus metallhaltiger Tinte mittels Tintenstrahldruck erzeugt und anschließend bei hoher Temperatur eingebrannt. Alternativ kann auch ein Formstück aus einem Blech unter Einsatz eines thermischen Trennverfahrens, beispielsweise durch Laserstrahlschneiden, oder durch Stanzen hergestellt sein. Der Einsatz thermischer Trenn- oder Stanzverfahren ermöglicht die Fertigung von Leiterbahnen in hoher Stückzahl und trägt so dazu bei, Material- und Fertigungskosten gering zu halten.

Durch den Einsatz von thermischen Trenn- oder Stanzverfahren können auch Werkstoffe zu einer Leiterbahn verarbeitet werden, die mittels Drucktechniken kaum oder nur aufwendig verarbeitet werden können. Dadurch, dass die Leiterbahn aus einem elektrisch leitenden und bei Stromdurchfluss wärmeerzeugenden Widerstandsmaterial gefertigt ist, wirkt diese als Heizelement. Ein flächighomogen abstrahlender Infrarotstrahler mit hoher Strahlungsleistung wird allerdings erst dann erhalten, wenn die Leiterbahn mit dem Träger in Verbindung gebracht wird. Hierzu wird beispielsweise die Leiterbahn als Formstück auf die Oberfläche des Trägers aufgebracht und mit dem Träger dauerhaft verbunden. Dabei kann die Leiterbahn mit dem Träger sowohl mechanisch als auch thermisch gefügt werden oder über eine nichtleitende Schicht verbunden werden. Im einfachsten Fall ist die Leiterbahn dem Träger in losem Verbund angefügt.

Darüber hinaus ist es beim Einsatz von thermischen Trenn- oder Stanzverfahren möglich, Fertigungsfehler, die bei der Herstellung der Leiterbahn auftreten können, frühzeitig zu erkennen. Insbesondere gegenüber einer unter Einsatz von Drucktechniken hergestellten Leiterbahn ist es möglich, die Leiterbahn-Formstücke vor dem Verfahrensschritt des Fügens mit dem Träger auf ihre Funktionsfähigkeit zu überprüfen. Als separates Bauteil kann die Leiterbahn beispielsweise einfach mit einer Spannung beaufschlagt werden. Hierdurch ist es möglich, eine fehlerhafte Leiterbahn auszusortieren, und zwar bevor die fehlerhafte Leiterbahn mit dem Träger verbunden wird, sodass die Entstehung von Ausschuss verringert und dadurch Herstellungskosten gesenkt werden können.

Es hat sich als günstig erwiesen, wenn die Leiterbahn aus Platin, hochtemperaturfestem Stahl, Tantal, einer ferritischen FeCrAl-Legierung, einer austenitischen CrFeNi-Legierung, Siliziumcarbid, Molydändisilicid oder einer Molybdän-Basislegierung gefertigt ist.

Die vorgenannten Werkstoffe, insbesondere Siliziumcarbid (SiC), Molybdändisilicid ($MoSi_2$), Tantal (Ta), hochwarmfester Stahl oder eine ferritische FeCrAl-Legierung wie Kanthal® (Kanthal ist eine eingetragene Marke der SANDVIK INTELLECTUAL PROPERTY AB, 811 81, Sandviken, SE) sind im Vergleich zu Edelmetallen, beispielsweise Gold, Platin oder Silber, kostengünstig; sie können einfach zu einem Leiterbahn-Formkörper umgeformt werden, der als Halbzeug bei der Herstellung des Infrarotflächenstrahlers eingesetzt werden kann. Sie sind insbesondere als Bleche verfügbar, aus denen einfach und kostengünstig eine Leiterbahn gefertigt werden kann. Darüber hinaus haben die vorgenannten Materialien den Vorteil, dass sie an Luft oxidationsbeständig sind, sodass eine zusätzliche, die Leiterbahn bedeckende Schicht (Deckschicht) zum Schutz der Leiterbahnen nicht zwingend notwendig ist.

Die Wärmeleistung eines jeden Leiterbahn-Abschnittes, ist abhängig vom spezifischen Widerstand des Widerstandsmaterials, der Leiterbahn-Abschnitt-Länge sowie dem Leiterquerschnitt. Durch Anpassung der Länge und des Leitungsquerschnitts ist eine einfache und schnelle Einstellung der Wärmeleistung des jeweiligen Leiterbahn-Abschnitts möglich.

Dabei gilt: Je größer der Leiterquerschnitt eines Leiterbahn-Abschnitts ist, desto geringer ist sein Widerstand und umso geringer ist seine Flächenleistung bei konstanter Anschlussspannung. Der Gesamtwiderstand und der bei konstanter Anschlussspannung fließende Strom ergeben sich aus der Summe der in Reihe geschalteten Widerstände.

Eine höhere Flächenleistung kann durch eine höhere Belegungsdichte mit Leitungen gleichen Querschnitts oder durch eine Erhöhung der Stromdichte oder durch einen dünneren Leitungsquerschnitt erzeugt werden.

Es hat sich daher besonders bewährt, wenn der Leiterquerschnitt der Leiterbahn des ersten Leiterbahn-Abschnitts im Bereich von 0,01 mm$^2$ bis 0,03 mm$^2$ und der Leiterquerschnitt der Leiterbahn des zweiten Leiterbahn-Abschnitts zwischen 0,025 mm$^2$ und 0,5 mm$^2$ liegt.

Es hat sich gezeigt, dass gute Ergebnisse hinsichtlich der Kompensation von Bestrahlungsstärke-Inhomogenitäten, wie sie üblicherweise bei Infrarotflächenstrahler beobachtet werden, erzielt werden können, wenn sich die Leiterquerschnittsflächen des ersten und des zweiten Leiterbahn-Abschnitts um mindestens 25 % voneinander unterscheiden. Vorzugsweise liegt der Unterschied der Leiterquerschnitte zwischen erstem und zweitem Leiterbahnabschnitt im Bereich von 30% bis 70%. bei Leiterquerschnitten von weniger als 0,01 mm$^2$ kann sich das Aufbringen als schwierig erweisen und die mechanische Haftung ist gering. Leiterquerschnitte von mehr als 0,5 mm$^2$ ergeben einen vergleichsweise geringen Widerstand und erfordern zum Beheizen daher relativ hohe Betriebsströme.

Leiterquerschnitte im Bereich von 0,01 und 0,5 mm$^2$ zeichnen sich durch ein besonders günstiges Spannungs-/Strom-Verhältnis aus; sie ermöglichen insbesondere einen Betrieb mit Spannungen im Bereich von 100 V bis 400 V bei Strömen von 1 A bis 4,5 A.

Eine Variation der Leitbahn-Länge ist durch geeignete Wahl der Form der Leiterbahn möglich. Im Hinblick auf eine möglichst homogene Temperaturverteilung hat es sich als vorteilhaft erwiesen, wenn die Leiterbahn als Linienmuster ausgeführt ist, das eine Fläche des Trägers derart bedeckt, dass zwischen benachbarten Leiterbahn-Abschnitten ein Zwischenraum von mindestens 1 mm, bevorzugt mindestens 2 mm, verbleibt.

Vorteilhafterweise ist die Leiterbahn als Linienmuster mit einer Belegungsdichte im Bereich von 25 % bis 85 % ausgeführt.

Bei einer geringen Belegungsdichte von weniger als 25% kann sich die Leiterbahn aus Seite der Heizfläche als Inhomogenität im Temperaturverlauf abzeichnen. Die Erhöhung der Belegungsdichte auf mehr als 85 % bringt keinen nennenswerten Zugewinn an Flächenleistung mehr. Erster und zweiter Leiterbahn-Abschnitt können dieselben oder unterschiedliche Belegungsdichten aufweisen. Über die Belegungsdichte ist eine Einstellung der Flächenleistung möglich. Die Einstellung der Flächenleistung kann dabei sowohl über eine geeignete Wahl der Belegungsdichte als auch über eine geeignete Wahl der Leiterquerschnitte erfolgen. Ein Leiterbahn-Abschnitt mit hoher Flächenleistung wird erhalten, wenn dessen Leiterquerschnitt gering ist oder wenn der Leiterbahn-Abschnitt eine hohe Belegungsdichte aufweist. Eine möglichst exakte Einstellung der Flächenleistungen von erstem und zweitem Leiterbahn-Abschnitt wird ermöglicht, wenn sich die Leiterbahn-Abschnitte sowohl in ihrem Leiterquerschnitt als auch ihrer Belegungsdichte unterscheiden.

Vorzugsweise liegt die Belegungsdichte des ersten Leiterbahn-Abschnitts bei maximal 75 % und die Belegungsdichte des zweiten Leiterbahn-Abschnitts im Bereich bei maximal 85%. Die zuvor genannten Belegungsdichten von erstem und zweitem Leiterbahn-Abschnitt sind einfach und kostengünstig herstellbar, beispielsweise durch Drucken.

Bei einer bevorzugten Ausgestaltung des erfindungsgemäßen Infrarotflächenstrahlers ist vorgesehen, dass die Leiterbahn mehrere erste Leiterbahn-Abschnitte und mehrere zweite Leiterbahn-Abschnitte umfasst, wobei erste und zweite Leiterbahn-Abschnitte wechselweise aufeinander folgen.

Durch das Vorsehen mehrerer, aufeinanderfolgender Leiterbahn-Abschnitte wird eine besonders flexible Anpassung der Bestrahlungsstärke und damit der Temperaturverteilung auf der Heizfläche ermöglicht, sodass die Ausbildung sogenannter *"cold spots"* oder *"hot spots"* vermieden werden kann. Dadurch, dass die mehreren Leiterbahn-Abschnitte in Reihe geschaltet sind, kann nahezu jedes beliebige Leiterbahn-Design realisiert werden.

Es hat sich besonders bewährt, wenn zwischen dem ersten Leiterbahn-Abschnitt und dem zweiten Leiterbahn-Abschnitt ein dritter Leiterbahn-Abschnitt zur Erzeugung eines Flächenleistungsgradienten angeordnet ist.

Ein Leiterbahn-Abschnitt korrespondiert mit einem Flächenbereich der Heizfläche, der mit einer konstanten Flächenleistung erwärmt wird. Der erste und der zweite Leiterbahn-Abschnitt können unmittelbar aneinander anschließen oder voneinander beanstandet sein. Ein gradueller Übergang zwischen dem ersten und dem zweiten Leiterbahn-Abschnitt trägt dazu bei, dass eine möglichst homogene Bestrahlungsleistung und eine homogene Temperaturverteilung auf der Heizfläche erzielt werden kann. Zu diesem Zweck kann zwischen dem ersten und dem zweiten Leiterbahn-Abschnitt ein dritter Leiterbahn-Abschnitt angeordnet sein, der derart ausgestaltet ist, dass er einen Flächenleistungsgradienten erzeugt. Hierdurch wird ein kontinuierlicher Übergang von der ersten Flächenleistung des ersten Leiterbahn-Abschnitts zur zweiten Flächenleistung des zweiten Leiterbahn-Abschnitts gewährleistet. Im einfachsten Fall ist der dritte Leiterbahn-Abschnitt so gestaltet, dass die Flächenleistung im dritten Leiterbahn-Abschnitt von der ersten Flächenleistung in die zweite Flächenleistung übergeht.

Bei einer bevorzugten Ausgestaltung des erfindungsgemäßen Infrarotflächenstrahlers ist vorgesehen, dass die Leiterbahnbelegungsfläche einen Randbereich und einen Mittenbereich aufweist, wobei der erste Leiterbahn-Abschnitt eine höhere Flächenleistung als der zweite Leiterbahn-Abschnitt aufweist und dem Randbereich zugeordnet ist, und der zweite Leiterbahn-Abschnitt dem Mittenbereich zugeordnet ist.

Es hat sich gezeigt, dass häufig der Randbereich eines Infrarotflächenstrahlers eine niedrigere Temperatur als der Mittenbereich aufweist. Eine Ursache hierfür ist, dass der Randbereich aufgrund seiner räumlichen Anordnung einem Wärmeabtransport besser zugänglich ist als der Mittenbereich. Es hat sich daher als günstig erwiesen, wenn insbesondere dem Randbereich ein Leiterbahn-Abschnitt mit höherer Flächenleistung zugeordnet ist, der den Wärmeabtransport kompensieren kann. Dies kann beispielsweise dadurch erreicht werden, dass die äußere Zone eine höhere Belegungsdichte oder einen geringeren Leiterquerschnitt aufweist.

Die Zusatzkomponente bestimmt maßgeblich die optischen und thermischen Eigenschaften des Trägers; genauer gesagt, sie bewirkt eine Absorption im infraroten Spektralbereich, das ist der Wellenlängenbereich zwischen 780 nm und 1 mm. Die Zusatzkomponente zeigt für mindestens einen Teil der Strahlung in diesem Spektralbereich eine Absorption, die höher ist als die der Matrixkomponente.

Die Phasenbereiche der Zusatzkomponente wirken in der Matrix als optische Störstellen und führen beispielsweise dazu, dass der Komposit-Werkstoff - je nach Schichtdicke - bei Raumtemperatur visuell schwarz oder grauschwärzlich erscheinen kann. Außerdem wirken die Störstellen selbst wärmeabsorbierend.

Im Komposit-Werkstoff liegt die Zusatzkomponente bevorzugt in einer Art und Menge vor, die im Komposit-Werkstoff bei einer Temperatur von 600 °C einen spektralen Emissionsgrad $\varepsilon$ von mindestens 0,6 für Wellenlängen zwischen 2 $\mu$m und 8 $\mu$m bewirkt. Bei einer besonders bevorzugten Ausführungsform des erfindungsgemäßen Infrarotflächenstrahlers liegt die Zusatzkomponente in einer Art und Menge vor, die im Träger-Werkstoff bei einer Temperatur von 1.000 °C einen spektralen Emissionsgrad $\varepsilon$ von mindestens 0,75 für Wellenlängen zwischen 2 $\mu$m und 8 $\mu$m bewirkt.

Der Träger-Werkstoff verfügt demnach über ein hohes Absorptions- und Emissionsvermögen für Wärmestrahlung zwischen 2 $\mu$m und 8 $\mu$m, also im Wellenlängenbereich der infraroten Strahlung. Dies vermindert die Reflexion an den Träger-Oberflächen, sodass sich unter der Annahme einer vernachlässigbar geringen Transmission ein Reflexionsgrad für Wellenlängen zwischen 2 $\mu$m und 8 $\mu$m und bei Temperaturen oberhalb von 1.000 °C bei maximal 0,25 und bei Temperaturen von 600 °C von maximal 0,4 ergibt. Nicht reproduzierbare Aufheizungen durch reflektierte Wärmestrahlung werden so vermieden, was zu einer gleichmäßigen oder gewünscht ungleichmäßigen Temperaturverteilung beiträgt.

Ein besonders hoher Emissionsgrad ist erzielbar, wenn die Zusatzkomponente als Zusatzkomponenten-Phase vorliegt und eine nicht-sphärische Morphologie mit maximalen Abmessungen von im Mittel weniger als 20 $\mu$m, vorzugsweise jedoch mehr als 3 $\mu$m aufweist.

Die nicht-sphärische Morphologie der Zusatzkomponenten-Phase trägt dabei auch zu einer hohen mechanischen Festigkeit und zu einer geringen Rissbildungsneigung des Komposit-Werkstoffs bei. Die Angabe "maximale Abmessung" bezieht sich auf die in Schliff erkennbare längste Ausdehnung eines isolierten Bereichs mit Zusatzkomponenten-Phase. Der Medianwert aller längsten Ausdehnungen in einem Schliffbild bildet den oben genannten Mittelwert.

Laut Kirchhoff'schem Strahlungsgesetz entsprechen spektraler Absorptionsgrad $\alpha_\lambda$ und spektraler Emissionsgrad $\varepsilon_\lambda$ eines realen Körpers im thermischen Gleichgewicht einander.

$$\alpha_\lambda = \varepsilon_\lambda \qquad\qquad (1)$$

Die Zusatzkomponente führt somit dazu, dass der Träger-Werkstoff Infrarotstrahlung emittiert. Der spektrale Emissionsgrad $\varepsilon_\lambda$ lässt sich bei bekannten gerichtethemisphärischen spektralen Reflexionsgrad $R_{gh}$ und Transmissionsgrad $T_{gh}$ wie folgt berechnen:

$$\varepsilon_\lambda = 1 - R_{gh} - T_{gh} \qquad\qquad (2)$$

Unter dem "spektralen Emissionsgrad" wird hierbei der "spektrale normale Emissionsgrad" verstanden. Dieser wird anhand eines Messprinzips ermittelt, das unter der Bezeichnung "Black-Body Boundary Conditions" (BBC) bekannt ist und veröffentlicht ist in "DETERMINING THE TRANSMITTANCE AND EMITTANCE OF TRANSPARENT AND SEMITRANSPARENT MATERIALS AT ELEVATED TEMPERATURES"; J. Manara, M. Keller, D. Kraus, M. Arduini-Schuster; 5th European Thermal-Sciences Conference, The Netherlands (2008).

Die amorphe Matrixkomponente hat im Komposit-Werkstoff, also in Verbindung mit der Zusatzkomponente, eine höhere Wärmestrahlungsabsorption als dies ohne die Zusatzkomponente der Fall wäre. Dadurch ergibt sich eine verbesserte Wärmeleitung von der Leiterbahn in den Träger, eine schnellere Verteilung der Wärme und eine höhere Abstrahlungsrate auf den Träger. Dadurch gelingt es, eine höhere Strahlungsleistung pro Flächeneinheit bereitzustellen und auch bei dünnen Träger-Wandstärken und/oder bei einer vergleichsweise geringen Leiterbahn-Belegungsdichte eine homogene Abstrahlung und ein gleichförmiges Temperaturfeld zu erzeugen. Ein Träger mit einer geringen Wandstärke verfügt über eine geringe thermische Masse und ermöglicht schnelle Temperaturwechsel. Eine Kühlung ist dafür nicht erforderlich.

Ausführungsbeispiel

Die Erfindung wird nachfolgend anhand von Ausführungsbeispielen und Zeichnungen näher erläutert. Dabei zeigt in schematischer Darstellung

**Figur 1** eine erste Ausführungsform eines erfindungsgemäßen Infrarotflächenstrahlers mit einer Leiterbahn, die im Randbereich eine höhere Belegungsdichte als im Mittenbereich aufweist,

**Figur 2** eine zweite Ausführungsform eines erfindungsgemäßen Infrarotflächenstrahlers mit einer Leiterbahn, die im Randbereich einen geringeren Leiterquerschnitt als im Mittenbereich aufweist,

**Figur 3** eine dritte Ausführungsform eines erfindungsgemäßen Infrarotflächenstrahlers, sowie ein Wärmebild, das die Temperaturverteilung des Substrats auf der Seite der Leiterbahnbelegung dieses Infrarotflächenstrahlers zeigt,

**Figur 4** eine vierte Ausführungsform eines erfindungsgemäßen Infrarotflächenstrahlers, bei der Leiterbahn-Abschnitte mit hohem und mit niedrigem elektrischem Widerstand wechselweise in Serie geschaltet sind,

**Figur 5** eine fünfte Ausführungsform eines erfindungsgemäßen Infrarotflächenstrahlers mit einem Träger aus einem einzigen Werkstoff,

**Figur 6** eine sechste Ausführungsform eines erfindungsgemäßen Infrarotflächenstrahlers mit einem Träger mit drei Werkstoff-Schichten, und

**Figur 7** eine siebte Ausführungsform eines erfindungsgemäßen Infrarotflächenstrahlers, bei dem der Träger einen ummantelten Träger-Kern aufweist.

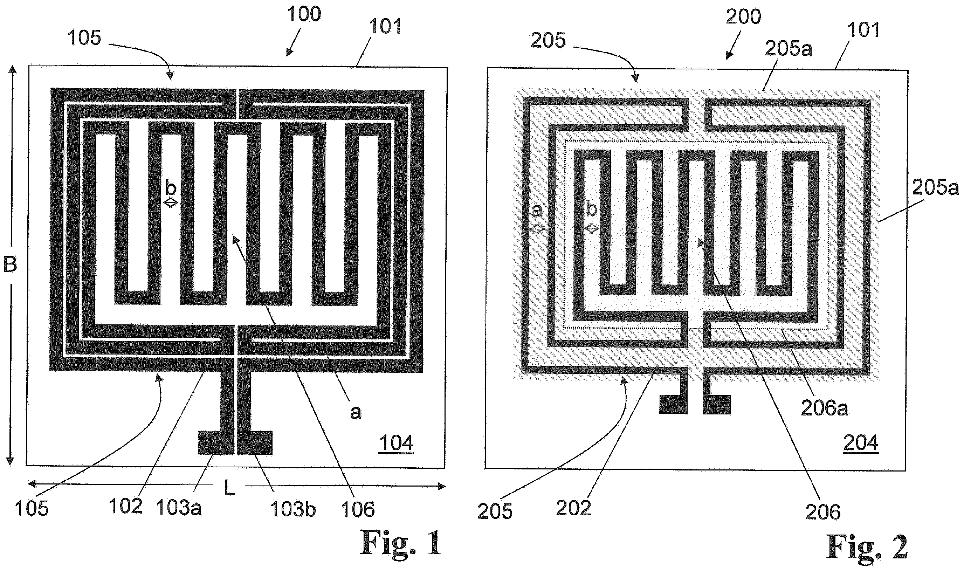

**Figur 1** zeigt eine Draufsicht auf eine erste Ausführungsform eines erfindungsgemäßen Infrarotflächenstrahlers, dem insgesamt die Bezugsziffer 100 zugeordnet ist. Der Infrarotflächenstrahler 100 ist für den Einsatz in einer Vorrichtung zur Herstellung flexibler gedruckter Elektronik (nicht dargestellt) geeignet. Er weist ein plattenförmiges Substrat (das ist der Träger im Sinne dieser Erfindung) 101, eine auf das Substrat 101 aufgebrachte Leiterbahn 102, sowie zwei Leitungsbahnen 103a, 103b zur elektrischen Kontaktierung der Leiterbahn 102 auf.

Das plattenförmige Substrat 101 ist aus Quarzglas mit einer chemischen Reinheit von 99,99 % und einem Cristobalit-Gehalt von 0,25 % gefertigt, das mit einem Zusatz von elementarem Silizium in Höhe von 5 % der Gesamtmasse versehen ist. Die Phase aus elementarem Silizium ist in dem Quarzglas in Form nicht-sphärischer Bereiche homogen verteilt. Die maximalen Abmessungen der Si-Phasenbereiche liegen im Mittel (Medianwert) im Bereich 1 $\mu$m bis 10 $\mu$m. Das plattenförmige Substrat 101 hat eine Dichte von 2,19 g/cm$^3$ und es hat eine Länge L von 100 mm, eine Breite B von 100 mm und eine Dicke von 2 mm. Das plattenförmige Substrat 101 wirkt visuell schwarz.

Die eingelagerte Si-Phase trägt einerseits zur Opazität des Substrats 101 insgesamt bei und sie hat Auswirkungen auf dessen optische und thermische Eigenschaften. Es zeigt bei hoher Temperatur eine hohe Absorption von Wärmestrahlung und einen hohen Emissionsgrad.

Bei Raumtemperatur wird der Emissionsgrad des Komposit-Werkstoffs unter Einsatz einer Ulbrichtkugel gemessen. Diese erlaubt die Messung des gerichtet hemisphärischen spektralen Reflexionsgrades $R_{gh}$ und des gerichtethemisphärischen spektralen Transmissionsgrades $T_{gh}$, woraus der normale spektrale Emissionsgrad berechnet wird. Die Messung des Emissionsgrades bei erhöhter Temperatur erfolgt im Wellenlängenbereich von 2 bis 18 $\mu$m mittels eines FTIR-Spektrometers (Bruker IFS 66v Fourier-Transformations Infrarot (FTIR)), an das über eine Zusatzoptik eine BBC-Probenkammer angekoppelt wird, anhand des oben genannten BBC-Messprinzips. Die Probenkammer verfügt dabei in den Halbräumen vor und hinter der Probenhalterung über temperierbare Schwarzkörperumgebungen und eine Strahlausgangsöffnung mit Detektor. Die Probe wird in einem separaten Ofen auf eine vorgegebene Temperatur aufgeheizt und zur Messung in den Strahlengang der Probenkammer mit den auf vorgegebene Temperatur eingestellten Schwarzkörperumgebungen verbracht. Die vom Detektor erfasste Intensität setzt sich aus einem Emissions-, einem Reflexions- und einem Transmissionsanteil zusammen, nämlich aus Intensität, die von der Probe selbst emittiert wird, Intensität, die vom vorderen Halbraum auf die Probe fällt und von dieser reflektiert wird, sowie Intensität, die vom hinteren Halbraum auf die Probe fällt und von dieser transmittiert wird. Zur Ermittlung der einzelnen Größen Emissions-, Reflexions- und Transmissionsgrad müssen drei Messungen durchgeführt werden.

Der am Substrat 101 gemessene Emissionsgrad im Wellenlängenbereich von 2 $\mu$m bis etwa 4 $\mu$m hängt von der Temperatur ab. Je höher die Temperatur ist, umso höher ist die Emission. Bei 600 °C liegt der normale Emissionsgrad im Wellenlängenbereich von 2 $\mu$m bis 4 $\mu$m oberhalb von 0,6. Bei 1000 °C liegt der normale Emissionsgrad im gesamten Wellenlängenbereich zwischen 2 µm und 8 µm oberhalb von 0,75.

Die Leiterbahn 102 ist aus einer Platin-Widerstandspaste erzeugt, in dem diese auf der Leiterbahnbelegungsfläche 104 des plattenförmigen Substrats 101 aufgedruckt und anschließend eingebrannt wurde. Die Leiterbahn 102 weist einen mäanderförmigen Verlauf auf und umfasst zwei Leiterbahn-Abschnitte 105, 106, wobei der erste Leiterbahn-Abschnitt 105 im Randbereich des Substrats 101 und der zweite Leiterbahn-Abschnitt 106 dem Mittenbereich des Substrats 101 zugeordnet ist. Um einer konvektionsbedingten, inhomogenen Temperaturverteilung auf dem Substrat 101 entgegenwirken zu können, ist der dem Randbereich zugeordnete Leiterbahn-Abschnitt 105 mit einer höheren Belegungsdichte auf das Substrat 101 aufgebracht als der dem Mittenbereich zugeordnete Leiterbahn-Abschnitt 106. Die Belegungsdichte des Leiterbahn-Abschnitts 105 beträgt 80 % und die Belegungsdichte des Leiterbahn-Abschnitts 106 beträgt 40 %, im Mittenbereich beträgt der Abstand b benachbarter Leiterbahnen 4,2 mm, im Randbereich beträgt der Abstand a benachbarter Leiterbahnen 0,7 mm.

Die Leiterbahn-Abschnitte 105, 106 zeichnen sich durch eine Querschnittsfläche von 0,028 mm$^2$ bei einer Breite von 2,8 mm und einer Dicke von 10 µm aus.

Sofern bei den in anderen Figuren gezeigten Ausführungsformen dieselben Bezugsziffern wie in Figur 1 verwendet sind, so sind damit baugleiche oder äquivalente Bauteile und Bestandteile bezeichnet, wie sie oben anhand der Beschreibung von Figur 1 näher erläutert sind.

**Figur 2** zeigt eine zweite Ausführungsform eines erfindungsgemäßen Infrarotflächenstrahlers, dem insgesamt die Bezugsziffer 200 zugeordnet ist. Der Infrarotflächenstrahler 200 umfasst ein plattenförmiges Substrat 101 eine auf das Substrat 101 aufgebrachte Leiterbahn 202, sowie zwei Leitungsbahnen 103a, 103b.

Der Infrarotflächenstrahler 200 unterscheidet sich von dem aus Figur 1 bekannten Infrarotflächenstrahler 100 im Wesentlichen im Leiterbahn-Design. Hinsichtlich des Substrats 101 wird auf die Beschreibung zu Figur 1 verwiesen.

Die Leiterbahnen 202 ist aus einer Platin-Widerstandspaste erzeugt, in dem diese auf die Oberseite 204 des plattenförmigen Substrats 101 aufgedruckt und anschließend eingebrannt wurde. Die Leiterbahn 202 weist einen mandelförmigen Verlauf auf und umfasst zwei Leiterbahn-Abschnitte 205, 206, wobei der erste Leiterbahn-Abschnitt 205 dem Randbereich des Substrats 101 und der zweite Leiterbahn-Abschnitt 206 dem Mittenbereich des Substrats 101 zugeordnet ist. Um einer konvektionsbedingten, inhomogenen Temperaturverteilung auf dem Substrat 101 entgegenwirken zu können, weist der dem Randbereich zugeordnete Leiterbahn-Abschnitt 205 einen höheren Widerstand als der dem Mittenbereich zugeordnete Leiterbahn-Abschnitt 206 auf. Der Leiterbahn-Abschnitt 205 hat einen Leiterquer-schnitt von 0,02 mm$^2$ bei einer Breite von 0,02 mm und einer Dicke von 10 µm. Der Leiterbahn-Abschnitt 206 hat einen Leiterquerschnitt von 0,028 mm$^2$ bei einer Breite von 2,8 mm und einer Dicke von 10 µm.

Im Mittenbereich beträgt der Abstand b benachbarter Leiterbahnen 4,18 mm; im Randbereich beträgt der Abstand a benachbarter Leiterbahnen 4,98 mm. Die Leiterbahnbreite (und damit auch der Leiterquerschnitt) ist im Mittenbereich 206 jedoch größer als im Randbereich 205, so dass die Abschnitte 205, 206 keine einheitliche Leiterbahn-Belegungsdichte haben. Im Mittenbereich 206 ergibt sich eine Belegungsdichte von 40%; und im Randbereich von 28,8%, bezogen auf die von der jeweiligen Leiterbahn belegte Träger-Fläche, die durch grau hinterlegte Flächenbereiche 205a (für die Träger-Fläche des Randbereichs 205) beziehungsweise 206a (für die Träger-Fläche des Mittenbereichs 206) repräsentiert sind.

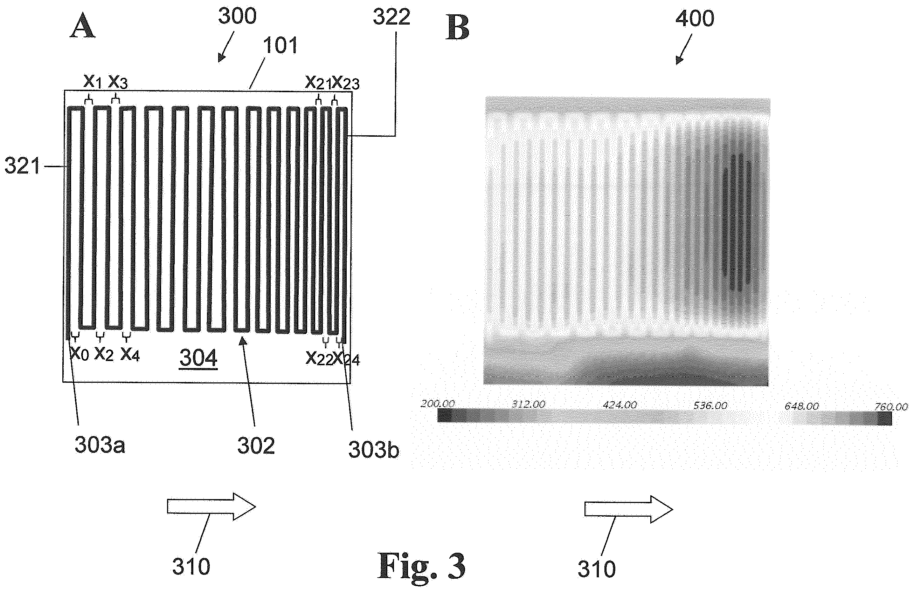

**Figur 3A** zeigt eine dritte Ausführungsform eines erfindungsgemäßen Infrarotflächenstrahlers, dem insgesamt die Bezugsziffer 300 zugeordnet ist. Der Infrarotflächenstrahler 300 umfasst ein Substrat 101, wie es anhand von Figur 1 näher beschrieben ist. Auf das Substrat 101 ist eine Leiterbahn 302 aufgebracht, die an ihren Enden mit Leitungsbahnen 303a, 303b versehen ist. Die Leiterbahn 302 ist zur Erzeugung eines Temperaturgradienten ausgelegt.

Zu diesem Zweck ist die auf die Oberfläche 304 des Substrats 101 aufgebrachte Leiterbahnen 302 derart ausgebildet, dass die Abstände $x_0$ bis $x_{22}$ benachbarter Leiterbahnen in Pfeilrichtung 310 gesehen kontinuierlich abnehmen, sodass die Belegungsdichte in Pfeilrichtung 310 gesehen zunimmt. Die Belegungsdichte beträgt im ersten Leiterbahn-Endabschnitt 321 40% und sie nimmt kontinuierlich zu bis sie im zweiten Leiterbahn-Endabschnitt 322 91 % beträgt.

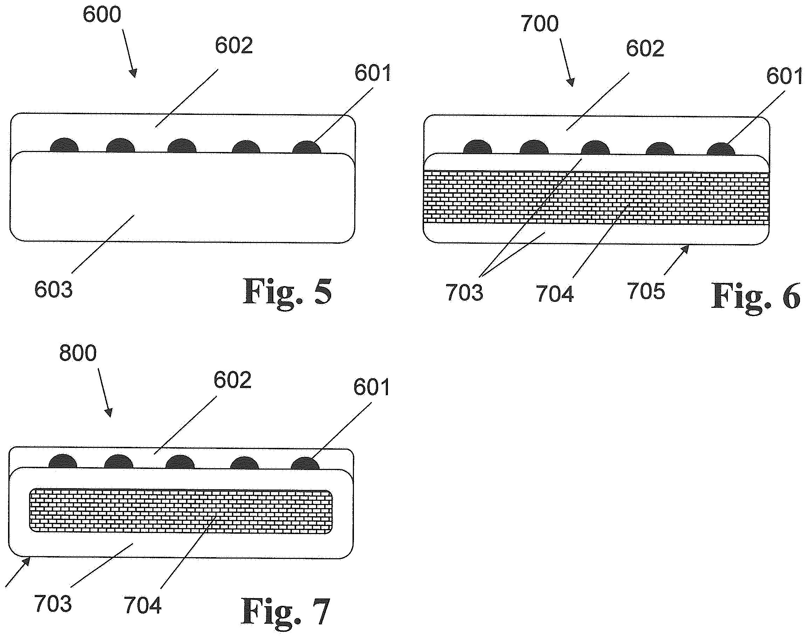

Die Leiterbahnen 302 wird durch Siebdruck erzeugt, wie dies weiter unten anhand des Ausführungsbeispiels von Figur 5 noch näher erläutert wird. Die Leiterbahn 302 weist in Pfeilrichtung 310 gesehen einen mäanderförmigen Verlauf auf. Die Leiterbahn 302 hat einen Leiterquerschnitt von 0,02 mm$^2$ bei einer Breite von 0,1 mm und einer Dicke von 20 µm.

Der Infrarotflächenstrahler 300 ist in einer Vorrichtung (nicht dargestellt) einsetzbar, die zur Herstellung flexibler gedruckter Elektronik im Rolle-zu-Rolle-Verfahren (R2R-Verfahren) bestimmt ist. In dieser Vorrichtung ist der Infrarotflächenstrahler 300 so angeordnet, dass die Transportrichtung (von Rolle zu Rolle) der Pfeilrichtung 310 entspricht. Hierdurch wird ermöglicht, dass zu Beginn der Bestrahlung eine geringe Leistung bereitgestellt wird, wie sie beispielsweise zum Trocknen der gedruckten Elektronik benötigt wird. Dadurch, dass die Belegungsdichte des Infrarotflächenstrahlers 300 in Transportrichtung gesehen zunimmt, wird das Heizgut während des Transports mit zunehmend höheren Bestrahlungsleistungen bestrahlt bis es am Ende des Bestrahlungsprozesses einer hohen Leistung exponiert ist, wie sie beispielsweise zum Sintern der gedruckten Elektronik benötigt wird. Die Bestrahlungsleistung beträgt zu Beginn des

Bestrahlungsprozesses 50 kW/m$^2$ und nimmt kontinuierlich zu bis am Ende 150 kW/m$^2$ erreicht werden.

Dieser Gradient spiegelt sich auch in der Temperaturverteilung auf der Heizfläche des Infrarotflächenstrahlers 300 wider. **Figur 3B** zeigt in Form eines Diagramms 400 die Temperaturverteilung auf der Heizfläche des Infrarotflächenstrahlers 300. In Abhängigkeit von der Belegungsdichte nimmt in Pfeilrichtung 310 gesehen die Temperatur der Heizfläche kontinuierlich zu, und zwar ausgehend von einer mittleren Temperatur von etwa 550 °C im linken Feld des Infrarotflächenstrahlers 300 bis auf eine Temperatur von 760 °C im rechten Feld des Infrarotflächenstrahlers 300.

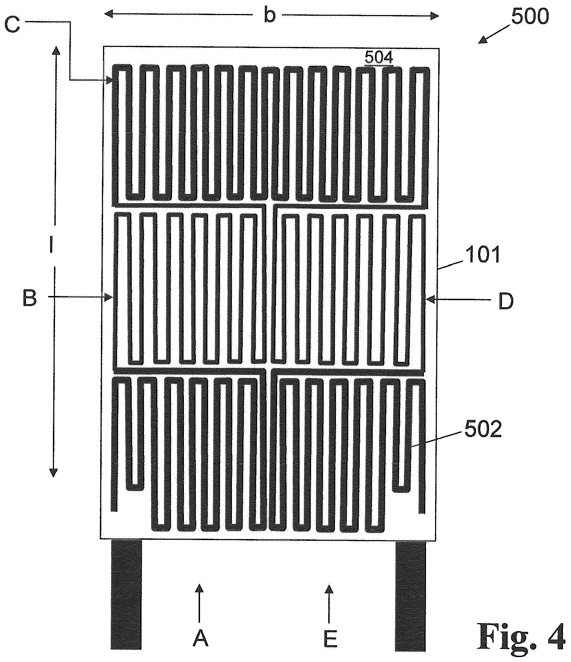

**Figur 4** zeigt eine vierte Ausführungsform eines erfindungsgemäßen Infrarotflächenstrahlers, dem insgesamt die Bezugsziffer 500 zugeordnet ist. Der Infrarotflächenstrahler 500 umfasst ein plattenförmiges Substrat 101, auf das eine Leiterbahn 502 mittels Siebdruck aufgebracht ist, wie erläutert im nachfolgend beschriebenen Ausführungsbeispiel von Figur 5..

Hinsichtlich des Substrats 101 wird auf die Beschreibung zu Figur 1 verwiesen. Es weist - abweichend von dem Substrat 100 aus Figur 1 - eine Länge l von 200mm, eine Breite b von 100mm und eine Dicke von 2 mm auf.

Die Leiterbahn 502 weist fünf in Reihe geschaltete Leiterbahn-Abschnitte auf, die mit den Bezugszeichen A bis E gekennzeichnet sind. Die Leiterbahn-Abschnitte B, D sind identisch ausgebildet; sie haben einen Leiterquerschnitt von 0,01 mm$^2$ bei einer Breite von 0,05 mm und einer Dicke von 20 $\mu$m. Die Leiterbahnen-Abschnitte A, E sind ebenfalls identisch ausgebildet und weisen einen Leiterquerschnitt von 0,02 mm$^2$ bei einer Breite von 0,1 mm und einer Dicke von 20 $\mu$m auf. Der Leiterbahn-Abschnitt C hat dieselbe Leiterbahnbreite und denselben Leiterquerschnitt wie die Abschnitte A, E unterscheidet sich lediglich in der Länge von den Abschnitten A, E. Abschnitt B hat dieselbe Leiterbahn-Belegungsdichte wie Abschnitt D. Die Leiterbahnbreite in diesen Abschnitten ist aber nur halb so groß wie die in den anderen Abschnitten A, E und C. Daher beträgt auch die Leiterbahn-Belegungsdichte in den Abschnitten B und D nur 50 % derjenigen der übrigen Abschnitte.

**Figur 5** zeigt eine fünfte Ausführungsform eines erfindungsgemäßen Infrarotflächenstrahlers 600 mit einem Substrat 603, einer auf das Substrat 603 aufgebrachten Leiterbahn 601 mit fünf Leiterbahn-Abschnitten und einer die Leiterbahn 601 bedeckende Deckschicht 602.

Das Substrat 603 ist aus demselben Werkstoff gefertigt wie das plattenförmige Substrat 101 in Figur 1. Auf die Ausführungen hierzu in Figur 1 wird verwiesen. Der Komposit-Werkstoff, aus dem das Substrat 603 gefertigt ist, ist ein elektrischer Isolator. Er besteht aus einer Matrixkomponente in Form von Quarzglas. In der Matrix ist eine Phase aus elementarem Silizium in Form nicht-sphärischer Bereiche homogen verteilt, deren Gewichtsanteil 5 % beträgt. Die maximalen Abmessungen der Silizium-Phasenbereiche liegen im Mittel (Medianwert) im Bereich von etwa 1 $\mu$m bis 10 $\mu$m. Der Komposit-Werkstoff ist gasdicht, er hat eine Dichte von 2,19 g/cm3 und er ist an Luft bis zu einer Temperatur von etwa 1150 °C stabil. Der Komposit-Werkstoff zeigt bei hohen Temperaturen eine hohe Absorption von Wärmestrahlung und einen hohen Emissionsgrad. Dieser hängt von der Temperatur ab. Bei 600 °C liegt der normale Emissionsgrad im Wellenlängenbereich von 2 $\mu$m bis 4 $\mu$m oberhalb von 0,6. Bei 1.000 °C liegt der normale Emissionsgrad im selben Wellenlängenbereich oberhalb von 0,75.

Die Leiterbahn 601 ist aus einer Platinpaste gefertigt, die auf das Substrat 603 mittels Siebdruck aufgetragen und anschließend eingebrannt wurde. Auf die Leiterbahnen 601 ist eine dünne Deckschicht 602 aus Quarzglas aufgebracht. Diese Deckschicht aus SiO$_2$ wurde über das Dickfilmverfahren im Siebdruck aufgebracht und hat eine mittlere Schichtdicke von 20-50 $\mu$m. Die Schicht ist riss- und porenfrei, um das Platin vor korrosiven Angriffen zu schützen.

Sofern in den in den Figuren 6 und 7 gezeigten Ausführungsformen dieselben Bezugsziffern wie in Figur 5 verwendet sind, so sind damit baugleiche oder äquivalente Bauteile und Bestandteile bezeichnet, wie sie oben anhand der Beschreibung von Figur 5 näher erläutert sind.

**Figur 6** zeigt eine weitere Ausführungsform eines erfindungsgemäßen Infrarotflächenstrahlers 700. Der Infrarotflächenstrahler 700 unterscheidet sich von dem Infrarotflächenstrahler 600 aus Figur 5 in der Substratzusammensetzung. Das Substrat 705, ist aus zwei Werkstoffen gebildet, die schichtartig miteinander verbunden sind. Die mittlere Schicht 704 besteht aus einem leitfähigen Material mit hohem Emissionsgrad, nämlich aus SiC. Die Schicht 704 kann aufgrund ihrer elektrischen Leitfähigkeit nicht unmittelbar mit der Leiterbahn 601 belegt werden. Die Schicht 704 ist daher an ihrer Ober- und an ihrer Unterseite jeweils von Schicht 703 aus Quarzglas bedeckt. Die Schichten 703 unterscheiden sich in ihrer Schichtdicke.

**Figur 7** zeigt eine siebte Ausführungsform eines erfindungsgemäßen Infrarotflächenstrahlers, dem die Bezugsziffer 800 zugeordnet ist. Der Infrarotflächenstrahler 800 weist ein Substrat 805 auf, das aus denselben Werkstoffen wie das Substrat 705 aus Figur 6 besteht. Der Werkstoff 704 bildet einen Substrat-Kern der von einer Schicht aus dem Werkstoff 703 umgeben ist.

**Patentansprüche**

**1.** Infrarotflächenstrahler (100, 200, 300, 500, 600, 700, 800), aufweisend einen Träger mit einer Heizfläche und mit einer auf einer Leiterbahnbelegungsfläche des Trägers aufgebrachten Leiterbahn (102, 202, 302, 502, 601) aus einem elektrisch leitenden und bei Stromdurchfluss wärmeerzeugenden Widerstandsmaterial, wobei die Leiterbahn (102, 202, 302, 502, 601) einen ersten Leiterbahn-Abschnitt (105, 205) zur Erzeugung einer ersten Flächenleistung und einen zweiten Leiterbahn-Abschnitt (106, 206) zur Erzeugung einer von der ersten Flächenleistung abweichenden, zweiten Flächenleistung umfasst, wobei der erste Leiterbahn-Abschnitt (105, 205) und der zweite Leiterbahn-Abschnitt (106, 206) in Reihe geschaltet sind und sich in ihrer Belegungsdichte und/oder ihrem Leiterquerschnitt voneinander unterscheiden, **dadurch gekennzeichnet, dass** der Träger einen Komposit-Werkstoff enthält, der eine amorphe Matrixkomponente sowie eine in die amorphe Matrixkomponente eingelagerte Zusatzkomponente in Form eines Halbleitermaterials umfasst.

2. Infrarotflächenstrahler (100, 200, 300, 500, 600, 700, 800) nach Anspruch 1, **dadurch gekennzeichnet, dass** der Träger vollständig aus dem Komposit-Werkstoff gefertigt ist, wobei der Komposit-Werkstoff ein elektrischer Isolator ist.

3. Infrarotflächenstrahler (100, 200, 300, 500, 600, 700, 800) nach Anspruch 1, **dadurch gekennzeichnet, dass** der Komposit-Werkstoff zumindest im Bereich der Leiterbahnbelegungsfläche mit einer Schicht aus einem elektrisch isolierenden Werkstoff überzogen ist.

4. Infrarotflächenstrahler (100, 200, 300, 500, 600, 700, 800) nach einem der vorhergehenden Ansprüche, **dadurch gekennzeichnet, dass** der Gewichtsanteil der Zusatzkomponente im Bereich zwischen 1 % und 5 %, vorzugsweise im Bereich zwischen 1,5 % und 3,5 % liegt.

5. Infrarotflächenstrahler (100, 200, 300, 500, 600, 700, 800) nach einem der vorhergehenden Ansprüche, **dadurch gekennzeichnet, dass** die Leiterbahnen (102, 202, 302, 502, 601) als eingebrannte Dickfilmschicht ausgeführt ist oder als Formstück derart auf die Oberfläche des Trägers aufgebracht ist, dass Leiterbahn (102, 202, 302, 502, 601) und Träger dauerhaft miteinander verbunden sind.

6. Infrarotflächenstrahler (100, 200, 300, 500, 600, 700, 800) nach einem der vorhergehenden Ansprüche, **dadurch gekennzeichnet, dass** die Leiterbahn (102, 202, 302, 502, 601) als Linienmuster mit einer Belegungsdichte im Bereich von 25 % bis 85 % ausgeführt ist.

7. Infrarotflächenstrahler (100, 200, 300, 500, 600, 700, 800) nach einem der vorhergehenden Ansprüche, **dadurch gekennzeichnet, dass** die Leiterbahn (102, 202, 302, 502, 601) im ersten Leiterbahn-Abschnitt (105, 205) einen Leiterquerschnitt im Bereich von 0,01 bis 0,03 $mm^2$ und die Leiterbahn im zweiten Leiterbahn-Abschnitt (106, 206) einen Leiterquerschnitt im Bereich von 0,025 bis 0,5 $mm^2$ hat.

8. Infrarotflächenstrahler (100, 200, 300, 500, 600, 700, 800) nach einem der vorhergehenden Ansprüche, **dadurch gekennzeichnet, dass** die Leiterbahn (102, 202, 302, 502, 601) mehrere erste Leiterbahn-Abschnitte und mehrere zweite Leiterbahn-Abschnitte umfasst, wobei erste und zweite Leiterbahnenabschnitte wechselweise aufeinander folgen.

9. Infrarotflächenstrahler (100, 200, 300, 500, 600, 700, 800) nach einem der vorhergehenden Ansprüche, **dadurch gekennzeichnet, dass** zwischen dem ersten Leiterbahn-Abschnitt und dem zweiten Leiterbahn-Abschnitt ein dritter Leiterbahn-Abschnitt zur Erzeugung eines Flächenleistungsgradienten angeordnet ist.

10. Infrarotflächenstrahler (100, 200, 300, 500, 600, 700, 800) nach einem der vorhergehenden Ansprüche, **dadurch gekennzeichnet, dass** die Leiterbahnbelegungsfläche einen Randbereich und einen Mittenbereich aufweist, wobei der erste Leiterbahn-Abschnitt (105, 205) eine höhere Flächenleistung als der zweite Leiterbahn-Abschnitt (106, 206) aufweist und dem Randbereich zugeordnet ist, und der zweite Leiterbahn-Abschnitt (106, 206) dem Mittenbereich zugeordnet ist.

11. Infrarotflächenstrahler (100, 200, 300, 500, 600, 700, 800) nach einem der vorhergehenden Ansprüche, **dadurch gekennzeichnet, dass** die Heizfläche eine Bestrahlungsleistung im Bereich von 200 kW/$m^2$ bis zu 250 kW/$m^2$ hat.

12. Infrarotflächenstrahler (100, 200, 300, 500, 600, 700, 800) nach einem der vorhergehenden Ansprüche, **dadurch gekennzeichnet, dass** die Zusatzkomponente eine eigene, in die amorphe Matrixkomponente dispergierte amorphe oder kristalline Phase bildet.

13. Infrarotflächenstrahler (100, 200, 300, 500, 600, 700, 800) nach einem der vorhergehenden Ansprüche, **dadurch**

**gekennzeichnet, dass** die Zusatzkomponente in einer Art und Menge vorliegt, die im Komposit-Werkstoff bei einer Temperatur von 600 °C einen spektralen Emissionsgrad ε von mindestens 0,6 für Wellenlängen zwischen 2 μm und 8 μm bewirkt.

14. Infrarotflächenstrahler (100, 200, 300, 500, 600, 700, 800) nach einem der vorhergehenden Ansprüche, **dadurch gekennzeichnet, dass** die Zusatzkomponente in einer Art und Menge vor liegt, die im Träger-Werkstoff bei einer Temperatur von 1.000 °C einen spektralen Emissionsgrad ε von mindestens 0,75 für Wellenlängen zwischen 2 μm und 8 μm bewirkt.

15. Infrarotflächenstrahler (100, 200, 300, 500, 600, 700, 800) nach einem der vorhergehenden Ansprüche, **dadurch gekennzeichnet, dass** die Zusatzkomponente als Zusatzkomponenten-Phase vorliegt und eine nicht-sphärische Morphologie mit maximalen Abmessungen von im Mittel weniger als 20 μm, vorzugsweise jedoch mehr als 3 μm aufweist.

**Claims**

1. An infrared panel radiator (100, 200, 300, 500, 600, 700, 800) having a carrier comprising a heating surface and comprising a conductor track (102, 202, 302, 502, 601) applied to a conductor track covering surface of the carrier of an electroconductive resistive material, which generates heat when current flows through, wherein the conductor track (102, 202, 302, 502, 601) comprises a first conductor track section (105, 205) for generating a first surface coverage and a second conductor track section (106, 206) for generating a second surface coverage, which differs from the first surface coverage, wherein the first conductor track section (105, 205) and the second conductor track section (106, 206) are connected in series and differ from one another in their covering density and/or their conductor cross section, **characterised in that** the carrier contains a composite material, which comprises an amorphous matrix component as well as an additional component in the form of a semiconductor material incorporated in the amorphous matrix component.

2. The infrared panel radiator (100, 200, 300, 500, 600, 700, 800) according to claim 1, **characterised in that** the carrier is made completely of the composite material, wherein the composite material is an electrical insulator.

3. The infrared panel radiator (100, 200, 300, 500, 600, 700, 800) according to claim 1, **characterized in that** the composite material is coated with a layer of an electrically insulating material at least in the region of the conductor track covering surface.

4. The infrared panel radiator (100, 200, 300, 500, 600, 700, 800) according to any one of the preceding claims, **characterised in that** the weight proportion by weight of the additional component lies in the range of between 1% and 5%, preferably in the range of between 1.5% and 3.5%.

5. The infrared panel radiator (100, 200, 300, 500, 600, 700, 800) according to any one of the preceding claims, **characterised in that** the conductor tracks (102, 202, 302, 502, 601) is embodied as burnt-in thick film layer or is applied to the surface of the carrier as moulded part in such a way that conductor track (102, 202, 302, 502, 601) and carrier are permanently connected to one another.

6. The infrared panel radiator (100, 200, 300, 500, 600, 700, 800) according to any one of the preceding claims, **characterised in that** the conductor track (102, 202, 302, 502, 601) is embodied as line pattern comprising a covering density in the range of from 25% to 85%.

7. The infrared panel radiator (100, 200, 300, 500, 600, 700, 800) according to any one of the preceding claims, **characterised in that** the conductor track (102, 202, 302, 502, 601) in the first conductor track section (105, 205) has a conductor cross section in the range of from 0.01 to 0.03 mm$^2$, and the conductor track in the second conductor track section (106, 206) has a conductor cross section in the range of from 0.025 to 0.5 mm$^2$.

8. The infrared panel radiator (100, 200, 300, 500, 600, 700, 800) according to any one of the preceding claims, **characterised in that** the conductor track (102, 202, 302, 502, 601) comprises several first conductor track sections and several second conductor track sections, wherein first and second conductor track sections alternate in sequence.

9. The infrared panel radiator (100, 200, 300, 500, 600, 700, 800) according to any one of the preceding claims, **characterised in that** a third conductor track section for generating a surface coverage gradient is arranged between the first conductor track section and the second conductor track section.

10. The infrared panel radiator (100, 200, 300, 500, 600, 700, 800) according to any one of the preceding claims, **characterised in that** the conductor track covering surface has an edge region and a middle region, wherein the first conductor track section (105, 205) has a higher surface coverage than the second conductor track section (106, 206) and is assigned to the edge region, and the second conductor track section (106, 206) is assigned to the middle region.

11. The infrared panel radiator (100, 200, 300, 500, 600, 700, 800) according to any one of the preceding claims, **characterised in that** the heating surface has an irradiation power in the range of from 200 kW/m$^2$ to 250 kW/m$^2$.

12. The infrared panel radiator (100, 200, 300, 500, 600, 700, 800) according to any one of the preceding claims, **characterised in that** the additional component forms a separate amorphous or crystalline phase, which is dispersed into the amorphous matrix component.

13. The infrared panel radiator (100, 200, 300, 500, 600, 700, 800) according to any one of the preceding claims, **characterised in that** the additional component is present in a type and quantity, which effects a spectral emission level ε of at least 0.6 for wavelengths between 2 μm and 8 μm in the composite material at a temperature of 600°C.

14. The infrared panel radiator (100, 200, 300, 500, 600, 700, 800) according to any one of the preceding claims, **characterised in that** the additional component is present in a type and quantity, which effects a spectral emission level ε of at least 0.75 for wavelengths between 2 μm and 8 μm in the carrier material at a temperature of 1,000°C.

15. The infrared panel radiator (100, 200, 300, 500, 600, 700, 800) according to any one of the preceding claims, **characterised in that** the additional component is present as additional component phase and has a non-spherical morphology with maximum dimensions of less than 20 μm on average, but preferably of more than 3 μm.

**Revendications**

1. Émetteur de surface infrarouge (100, 200, 300, 500, 600, 700, 800), présentant un support avec une surface chauffante et avec une piste conductrice (102, 202, 302, 502, 601) posée sur une surface d'affectation de la piste conductrice du support, composée d'un matériau à résistance électriquement conducteur et générateur de chaleur lorsqu'un courant circule, la piste conductrice (102, 202, 302, 502, 601) comprenant une première section de piste conductrice (105, 205) pour la génération d'un premier rendement surfacique et une deuxième section de piste conductrice (106, 206) pour la génération d'un deuxième rendement surfacique différent du premier rendement surfacique, la première section de piste conductrice (105, 205) et la deuxième section de piste conductrice (106, 206) étant montées en série et se distinguant l'une de l'autre dans leur densité d'affectation et/ou leur section de conducteur, **caractérisé en ce que** le support contient un matériau composite qui comprend un composant-matrice amorphe ainsi qu'un composant supplémentaire sous la forme d'un matériau de semi-conducteur, stocké dans le composant-matrice amorphe.

2. Émetteur de surface infrarouge (100, 200, 300, 500, 600, 700, 800) conformément à la revendication n°1, **caractérisé en ce que** le support est entièrement fabriqué à partir du matériau composite, le matériau composite étant un isolateur électrique.

3. Émetteur de surface infrarouge (100, 200, 300, 500, 600, 700, 800) conformément à la revendication n°1, **caractérisé en ce que** le matériau composite est revêtu, au moins dans la zone de la surface d'affectation de la piste conductrice, d'une couche fabriquée dans un matériau électriquement isolant.

4. Émetteur de surface infrarouge (100, 200, 300, 500, 600, 700, 800) conformément à l'une des revendications précédentes, **caractérisé en ce que** le rapport de poids du composant supplémentaire est compris entre 1% et 5%, de préférence entre 1,5% et 3,5%.

5. Émetteur de surface infrarouge (100, 200, 300, 500, 600, 700, 800) conformément à l'une des revendications précédentes, **caractérisé en ce que** la piste conductrice (102, 202, 302, 502, 601) est conçue comme couche à pellicule épaisse cuite ou est posée comme pièce moulée sur la surface du support de telle manière à ce que la piste conductrice (102, 202, 302, 502, 601) et le support soient durablement reliés.

6. Émetteur de surface infrarouge (100, 200, 300, 500, 600, 700, 800) conformément à l'une des revendications précédentes, **caractérisé en ce que** la piste conductrice (102, 202, 302, 502, 601) est conçue comme structure linéaire avec une densité d'affectation comprise entre 25% et 85%.

7. Émetteur de surface infrarouge (100, 200, 300, 500, 600, 700, 800) conformément à l'une des revendications précédentes, **caractérisé en ce que** la piste conductrice (102, 202, 302, 502, 601) dans la première section de piste conductrice (105, 205) a une section de conducteur comprise entre 0,01 et 0,03 mm$^2$ et la piste conductrice dans la deuxième section de piste conductrice (106, 206) a une section de conducteur comprise entre 0,025 et 0,5 mm$^2$.

8. Émetteur de surface infrarouge (100, 200, 300, 500, 600, 700, 800) conformément à l'une des revendications précédentes, **caractérisé en ce que** la piste conductrice (102, 202, 302, 502, 601) comprend plusieurs premières sections de piste conductrice et plusieurs deuxièmes sections de piste conductrice, les premières et deuxièmes sections de piste conductrice se suivant en alternance.

9. Émetteur de surface infrarouge (100, 200, 300, 500, 600, 700, 800) conformément à l'une des revendications précédentes, **caractérisé en ce qu'**une troisième section de piste conductrice pour la génération d'un gradient de rendement surfacique est disposée entre la première section de piste conductrice et la deuxième section de piste conductrice.

10. Émetteur de surface infrarouge (100, 200, 300, 500, 600, 700, 800) conformément à l'une des revendications précédentes, **caractérisé en ce que** la surface d'affectation de la piste conductrice présente une zone marginale et une zone médiane, la première section de piste conductrice (105, 205) présentant un rendement surfacique plus élevé que la deuxième section de piste conductrice (106, 206) et étant affectée à la zone marginale et la deuxième section de piste conductrice (106, 206) étant affectée à la zone médiane.

11. Émetteur de surface infrarouge (100, 200, 300, 500, 600, 700, 800) conformément à l'une des revendications précédentes, **caractérisé en ce que** la surface chauffante a une puissance d'irradiation comprise entre 200 kW/m$^2$ et 250 kW/m$^2$.

12. Émetteur de surface infrarouge (100, 200, 300, 500, 600, 700, 800) conformément à l'une des revendications précédentes, **caractérisé en ce que** le composant supplémentaire forme une propre phase amorphe ou cristalline dispersée dans le composant-matrice amorphe.

13. Émetteur de surface infrarouge (100, 200, 300, 500, 600, 700, 800) conformément à l'une des revendications précédentes, **caractérisé en ce que** le composant supplémentaire est présent dans une nature et une quantité entraînant une émissivité spectrale $\varepsilon$ d'au moins 0,6 pour des longueurs d'onde comprises entre 2 $\mu$m et 8 $\mu$m à une température de 600°C dans le matériau composite.

14. Émetteur de surface infrarouge (100, 200, 300, 500, 600, 700, 800) conformément à l'une des revendications précédentes, **caractérisé en ce que** le composant supplémentaire est présent dans une nature et une quantité entraînant une émissivité spectrale $\varepsilon$ d'au moins 0,75 pour des longueurs d'onde comprises entre 2 $\mu$m et 8 $\mu$m à une température de 1 000°C dans le matériau support.

15. Émetteur de surface infrarouge (100, 200, 300, 500, 600, 700, 800) conformément à l'une des revendications précédentes, **caractérisé en ce que** le composant supplémentaire est présent comme phase de composant supplémentaire et présente une morphologie non-sphérique avec des dimensions maximales de moins de 20 $\mu$m en moyenne, toutefois de préférence de plus de 3 $\mu$m.

Fig. 2

101
205a
205a
200
205
205
205
204
206a
206
202

Fig. 1

101
100
105
105
104
a
b
106
103b
L
103a
102
105
B

Fig. 3

EP 3 516 925 B1

Fig. 4

EP 3 516 925 B1

600

602

601

603

**Fig. 5**

700

602

601

703  704  705

**Fig. 6**

800

602

601

703  704

**Fig. 7**

EP 3 516 925 B1

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- DE 102014108356 A1
- DE 20202810 U1
- US 20140314396 A1
- WO 2012139883 A1
- DE 112014003822 T5
- EP 0495770 A1
- FR 979374 A

### In der Beschreibung aufgeführte Nicht-Patentliteratur

- **J. MANARA ; M. KELLER ; D. KRAUS ; M. ARDUINI-SCHUSTER.** DETERMINING THE TRANSMITTANCE AND EMITTANCE OF TRANSPARENT AND SEMITRANSPARENT MATERIALS AT ELEVATED TEMPERATURES. *5th European Thermal-Sciences Conference,* 2008